# EUROPEAN PATENT APPLICATION

(11) **EP 4 443 658 A1**
(43) Date of publication of application: **09.10.2024**
(21) Application number: 23275058.8
(22) Date of filing: 06.04.2023
(51) Int. Cl.: H01R 4/68, H01B 12/00, H02G 15/34

(54) **METHODS AND MEANS FOR SUPERCONDUCTING JOINTING**

(71) Applicant: Siemens Healthcare Limited, Camberley, Surrey GU15 3YL (GB)
(72) Inventor: Calvert, Simon James, Finstock, Chipping Norton, OX7 3BY (GB)
(74) Representative: Maier, Daniel Oliver

(57) **Abstract**

The invention relates to a method for forming a superconducting joint between superconducting elements (30) and a method for forming a superconducting joint between superconducting elements (30) and a compressing element (36). Furthermore, the invention relates to a superconducting magnet comprising a first superconducting element (30a) and a second superconducting element (30b) connected via a superconducting joint, wherein the first superconducting element (30a) and the second superconducting element (30b) are held together by a compressing element (36) and/or a counter piece (37) along a section of the first superconducting element (30a) and the second superconducting element (30b) comprising the superconducting joint. The invention also relates to a magnetic resonance imaging device (11) comprising an inventive superconducting magnet and a manufacturing device (50) configured for joining superconducting elements (30) via an inventive method.

## Description

The invention relates to a method for forming a superconducting joint. Furthermore, the invention relates to a superconducting magnet comprising a first superconducting element and a second superconducting element connected via a superconducting joint

In recent times, processes of jointing superconducting wires have concentrated on using nitric and hydrofluoric acids to remove copper and/or de-oxidize superconducting filaments contained within the superconducting wires. These acids pose a threat to health and safety of technicians and require the use of specialized fume cupboards to remove fumes arising during etching of the superconducting wires. Processes for jointing of superconducting wires also often involve the use of lead, which poses a threat to health and the environment and is likely to be eliminated from industrial processes in the future. Furthermore, expensive metals, such as indium, are used as a wetting agent, thus increasing costs of the already labour-intensive and demanding processes.

Ultrasonic welding jointing methods are being developed but rely on the use of concentrated nitric acid to remove the copper. Thus, jointing methods using ultrasonic welding still require the use of fume cupboards. Furthermore, ultrasonic jointing methods also rely on highly skilled technicians to ensure formation of effective superconducting joints.

Other known superconducting jointing methods, such as welding, cold welding and mechanical consolidation of superconducting filaments, are time-intensive, require the use of acids and/or cannot be used for jointing superconducting wires comprising filamentary conductors.

Therefore, superconducting jointing methods are usually not automated and/or require intervention from skilled technicians as well as expensive equipment, such as ultrasonic welding machines, for each operator.

Independent of the grammatical term usage, individuals with male, female or other gender identities are included within the term.

It is an objective of the invention to reduce costs and/or complexity associated with superconducting jointing processes.

This objective is achieved by a method for forming a superconducting joint, a superconducting magnet, a magnetic resonance imaging device and a manufacturing device according to the invention. Further advantageous embodiments are specified in the dependent claims.

The inventive method relates to forming a superconducting joint between superconducting elements.

Superconducting joints are primarily used for joining superconducting elements, i. e. sections of superconducting leads or wires. The superconducting elements may be used as superconducting magnets in magnetic resonance imaging devices. However, the superconducting elements may also be used for transportation of electrical currents in other technical fields.

The superconducting elements may comprise a superconducting material, such as NbTi, MgB2 and Nb3Sn, having negligible electrical resistance at (or below) a superconducting temperature. Preferably, the superconducting elements comprise an outer shell or wrapping. The outer shell or wrapping may comprise or consist of a metal with high electrical conductivity, but also high thermal conductivity. Particularly, the outer shell or wrapping may consist of a metal such as gold, copper, aluminium, platinum, silver. The superconducting elements may comprise filaments of the superconducting material enclosed in the outer shell or wrapping.

A magnetic resonance imaging device may comprise a cryocooler configured to provide a temperature below a superconducting temperature of a superconducting material of a main magnet. The magnetic resonance imaging device may also comprise a cryostat including a sealed container or vacuum vessel configured for storing or preserving a fluid, preferably a cryogen, at a predefined temperature level. The fluid and the main magnet may be thermally connected. Preferably, the predefined temperature level of the fluid may substantially correspond to the superconducting temperature of the main magnet. For example, a superconducting temperature of the main magnet may be in the range of 3 K to 100 K, preferably in the range of 3 K to 5 K, 30 K to 60 K, or 60 K to 90 K.

The inventive method for forming a superconducting joint between superconducting elements comprises a plurality of steps.

In one step of the inventive method, material is removed from a surface of a first superconducting element to expose a filament of the first superconducting element and provide a joining surface. Preferably, the inventive method further comprises a step of removing material from a surface of a second superconducting element to provide a second joining surface on the second superconducting element. However, the joining surface of the second superconducting element may also be provided via a different process, i. e. by etching using acids or the like.

Preferably, the material is removed from the surface of the first superconducting element using a mechanical process. In particular, the process of removing material from the surface of the first superconducting element may avoid the use of chemical agents for removing material, such as acids.

According to an embodiment of the inventive method, a grinding, cutting and/or milling process is used to remove material from the surface of the first superconducting element. However, any mechanical process suitable for removing material from a superconducting element may be used.

In mechanically removing material from the superconducting element, the use of acids and fume cupboards may favourably be avoided. Thus, health and safety risks, but also costs for purchasing and disposing of concentrated acids may favourably be decreased or eliminated.

In a further step of the inventive method, the first superconducting element and a second superconducting element are oriented in such a way, that the joining surface of the first superconducting element is oriented towards a joining surface of the second superconducting element. The joining surface of the first superconducting element and the joining surface of the second superconducting element are brought into contact to form a stack of superconducting elements.

Preferably, the step of orienting the first superconducting element and the second superconducting element relative to one another and bringing into contact or joining the joining surface of the first superconducting element and the joining surface of the second superconducting element is performed automatically via a dedicated machine.

In a preferred embodiment, the joining surface of the first superconducting element and the joining surface of the second superconducting element are joined promptly, for example within hours, minutes or preferably seconds, after the material has been removed from the first superconducting element and/or the second superconducting element. Thus, an oxidation of the joining surface of the first superconducting element and/or the second superconducting element may favourably be avoided.

The joining surface of the first superconducting element and the joining surface of the second superconducting element may overlap to a certain degree when brought into contact. For example, the joining surface of the first superconducting element and the joining surface of the second superconducting element may overlap to a degree of more than 70%, more than 80%, more than 90% or more than 95%.

It is conceivable, that the step of orienting the first superconducting element and the second superconducting element relative to one another and/or bringing into contact or joining the joining surface of the first superconducting element and the joining surface of the second superconducting element is performed manually by a technician. However, the step may also be carried out automatically, for example via a dedicated manufacturing device.

According to a further step of the inventive method, [PP(TIDC1] the stack of superconducting elements is compressed to form the superconducting joint between the superconducting elements.

In one embodiment, the stack of superconducting elements may be compressed in a simple press. For example, the stack of superconducting elements may be compressed between two walls or two plates, or the like. However, the stack of superconducting elements may also be compressed by one or more platens or rollers.

Preferably, the stack of superconducting elements is mechanically compressed by applying pressure. In one embodiment, the stack of superconducting elements may be wedged or compressed between two walls of a single-piece or multi-piece tool. For example, the stack of superconducting elements may be compressed or wedged between a compressing element and a counter piece according to an embodiment described below.

It is conceivable, that a material bond is formed between the first superconducting element and the second superconducting element, particularly between an exposed filament on the joining surface of the first superconducting and an exposed filament on the joining surface of the second superconducting element, when the stack of superconducting elements is compressed. It is also conceivable that a contact area between the exposed filament of the first superconducting and the exposed filament of the second superconducting element is increased, when the stack of superconducting elements is compressed.

The compression of the stack of superconducting elements preferably provides a mechanical and electrical connection between the superconducting elements. It is also conceivable, that the stack of superconducting elements is mechanically connected to the compressing element and/or the counter piece. The superconducting elements may also be electrically connected to the compressing element and/or the counter piece.

The mechanical connection between the stack of superconducting elements and the compressing element and/or the counter piece may comprise a material bond, a force-locking connection and/or a form-locking connection.

The inventive method enables jointing of superconducting elements in a purely mechanical process. Thus, the use of wetting agents, lead (alloys) and/or acids can favourably be avoided. In particular, lead may favourably be eliminated from superconducting jointing processes, thus ensuring compliance with future RoHS (Restriction of Hazardous Substances) directives.

As a further advantage, the inventive method may favourably be automated using a simple machine. Thus, the jointing process can be organized and/or monitored by less-skilled technicians or personnel.

According to an embodiment, the inventive method further comprises the step:
- deforming the first superconducting element by applying pressure to provide a substantially planar surface on the first superconducting element,
wherein removing material from a surface of the first superconducting element comprises removing material from the planar surface of the first superconducting element.

The deforming of the first superconducting element may involve flattening and/or straightening of at least a section of the first superconducting element. In one embodiment, the deforming of the first superconducting element is restricted to a predefined section of the superconducting element, preferably a section of an end piece of the first superconducting element.

It is conceivable, that an oval-shaped or polygonal-shaped cross-section of the first superconducting element is transformed into a substantially rectangular-shaped or pill-shaped cross-section having at least one planar surface or side by deforming the first superconducting element.

For example, the first superconducting element may be deformed by pressing the first superconducting element between two walls. It is also conceivable, that a platen is used to deform the first superconducting element.

Preferably, an end piece of the first superconducting element is formed into a flat ribbon when deforming the first superconducting element.

In one embodiment, the inventive method involves the further step:
- deforming the second superconducting element by applying pressure to provide a substantially planar surface on the second superconducting element.

In a preferred embodiment, the first superconducting element and the second superconducting element are deformed at the same time. For example, the first superconducting element and the second superconducting element may be stacked or positioned in proximity to one another to form a stack of superconducting elements so that the first superconducting element and the second superconducting element can be deformed concurrently or in a synchronous manner, for example in a single operation and/or in a single machine.

In deforming a superconducting element, a surface area of a joining surface for joining the superconducting elements may favourably be increased.

In providing a planar surface on a superconducting element, an amount of material to be removed when exposing the filaments of the superconducting elements may favourably be reduced. Thus, waste material can be reduced and/or a usage of the superconducting material can be increased.

According to a further embodiment, the inventive method comprises the step of:
- positioning the stack of superconducting elements in a predefined relative position between a compressing element and a counter piece,
wherein compressing the stack of superconducting elements comprises wedging the stack of superconducting elements between the counter piece and the compressing element by bringing together the compressing element and the counter piece.

The counter piece and the compressing element may comprise interlocking shapes. For example, the counter piece may comprise a recess or opening and the compressing element may comprise a complementary protrusion or structural feature, preferably offset by an estimated thickness of the superconducting elements. In one embodiment, the protrusion or structural feature of the compressing element may be undersized with respect to the recess or opening of the counter piece to account for a volume of the stack of superconducting elements in a compressed state.

A section of the stack of superconducting elements may be pushed or guided into the recess or opening in the counter piece when the compressing element and the counter piece are brought together. Thus, a form-locking and/or force-locking mechanical connection may be formed between the stack of superconducting elements and the counter piece and/or the compressing element.

In one embodiment of the inventive method, bringing together the compressing element and the counter piece may comprise guiding the compressing element towards an opening of the counter piece. However, bringing together the compressing element and the counter piece may also comprise guiding the opening of the counter piece towards the compressing element or guiding the compressing element and the counter piece towards each other.

Positioning the stack of superconducting elements in a predefined relative position between the compressing element and the counter piece may comprise positioning a section with the joining surfaces of the superconducting elements about an opening or recess of the counter piece and/or a protrusion or structural feature of the compressing element. Thus, a superconducting joint may be formed along the joining surfaces of the first superconducting element and the second superconducting element when the stack of superconducting elements is compressed.

In positioning the superconducting elements in a predefined relative position between a compressing element and a counter piece, the formation of superconducting joints may favourably occur along sections of the superconducting elements comprising joining surfaces.

According to a further embodiment of the inventive method, the counter piece comprises an inner bore and the compressing element comprises a pin, wherein the method for forming a superconducting joint between superconducting elements comprises the further step of:
- forming the stack of superconducting elements onto the pin,
wherein compressing the stack of superconducting elements comprises wedging the stack of superconducting elements between a wall of the inner bore of the counter piece and the pin by positioning the pin within the inner bore of the counter piece.

Forming the stack of superconducting elements onto the pin may comprise winding the stack of superconducting elements along a shaft of the pin. However, forming the stack of superconducting elements onto the pin may also comprise forming the stack of superconducting elements over a tip or pinnacle of the pin in such a way, that the stack of superconducting elements confines the shaft of the pin from two substantially opposing directions. Of course, other possibilities of forming or winding the stack of superconducting elements onto the pin are conceivable. For example, the stack of superconducting elements may be formed onto the pin by guiding the pin into the inner bore of the counter piece.

By wedging the stack of superconducting elements between the wall of the inner bore and the pin, the superconducting joint may be formed along a U-shaped, a V-shaped or a spiral section of the stack of superconducting elements. Thus, the superconducting joint may be provided in a space-efficient manner.

As a further advantage, the pin may easily be secured via a securing element, such as a crossbar, a securing pin, or a similar mechanism, in order to prevent unintentional detachment of the pin from the counter piece.

Furthermore, the pin may favourably be used to apply a high pressure on a limited surface area of the stack of superconducting elements, thus ensuring a formation of the superconducting joint.

In one embodiment of the inventive method, the counter piece comprises an opening and the compressing element comprises a bracket, wherein the method for forming a superconducting joint between superconducting elements comprises the step:
- positioning the stack of superconducting elements between two arms of the bracket,
wherein compressing the stack of superconducting elements comprises wedging the stack of superconducting elements between the two arms of the bracket by positioning the bracket within the opening of the counter piece.

In all embodiments described herein, an opening of the counter piece may represent a recess, an indentation, an inner bore, a slot, a notch, or a groove, in the counter piece. Preferably, the opening may be formed in such a way, that the stack of superconducting elements and/or a section of the compressing element may be accommodated within the opening.

As described above, the opening in the counter piece and the bracket may comprise interlocking shapes or complementary shapes. For example, an outer shape or surface of a section of the bracket may conform to an inner shape or surface of the opening. Preferably, the bracket or an outer dimension of the bracket is oversized with respect to the opening in such a way, that the bracket itself is compressed when positioned within the opening of the counter piece. Thus, when the bracket is compressed, the stack of superconducting elements between the two walls of the bracket is compressed as well, forming the superconducting joint.

The two walls of the bracket may correspond to two arms or blades of the bracket. The two walls of the bracket may be flexible. However, the two walls of the bracket may also be configured to be plastically deformed under load or exposure to a predetermined force. A gap between the two walls of the bracket may be large enough to accommodate the stack of superconducting elements without compressing the superconducting elements or with minimal compression. Preferably, the section of the superconducting elements comprising the joining surfaces is positioned within the two walls of the bracket.

In a preferred embodiment, the bracket as well as the superconducting elements are compressed when guiding the bracket into the opening of the counter piece, thus forming the superconducting joint between the superconducting elements.

By compressing the stack of superconducting elements between two walls of a bracket positioned within an opening of the counter piece, the superconducting joint may be formed in a simple and reproduceable manner. Thus, the inventive method may favourably be automatized or performed by less-trained personnel.

The inventive method for forming a superconducting joint between superconducting elements a compressing element comprises a plurality of steps.

According to a step of the inventive method, material is removed from a first surface of a first superconducting element and from a second surface of a second superconducting element to expose filaments of the first superconducting element and of the second superconducting element and provide a first joining surface on the first superconducting element and a second joining surface on the second superconducting element.

The removing of material from the superconducting elements (i. e. the first superconducting element and the second superconducting element) may be performed according to an embodiment described above. Preferably, the material is mechanically removed from the first surface of the first superconducting element and from the second surface of the second superconducting element.

In another step of the inventive method, the first superconducting element and the second superconducting element are oriented in such a way, that the first surface and the second surface are facing in opposite directions. The first superconducting element and the second superconducting element are brought into contact to form a stack of superconducting elements.

Orienting and/or bringing into contact the first superconducting element and the second superconducting element may be performed automatically or manually. Preferably, the step of orienting and bringing into contact the superconducting elements precedes the step of removing material from the superconducting elements. However, the step of orienting and/or bringing into contact the superconducting elements may also be performed after the step of removing material from the superconducting elements to expose the filaments.

According to a further step of the inventive method, the stack of superconducting elements is positioned between two walls of a compressing element, wherein the first joining surface is oriented towards a first wall of the compressing element and the second joining surface is oriented towards a second wall of the compressing element.

Preferably, the step of orienting the first superconducting element and the second superconducting element comprises orienting the superconducting elements in such a way, that the first joining surface and the second joining surface are facing in different directions, particularly opposite directions. Thus, the superconducting elements may be brought into contact or joined along sides or surfaces which do not comprise exposed filaments.

In one step of the inventive method, the stack of superconducting elements is compressed between the two walls of the compressing element to form the superconducting joint between the superconducting elements and the compressing element.

As the first joining surface is oriented towards the first wall of the compressing element and the second joining surface is oriented towards the second wall of the compressing element, the superconducting elements form superconducting joints with the two walls of the compressing element when the superconducting elements are compressed between the two walls of the compressing element.

As described above, a material bond may be formed between the superconducting elements, particularly the filaments of the superconducting elements, and the compressing element, when the superconducting elements are compressed between the two walls of the compressing element. However, the superconducting elements may also be mechanically and electrically connected to the compressing element.

In a preferred embodiment the compressing element comprises or consists of a superconducting material.

The superconducting elements may be compressed between the two arms of the bracket by exerting a force onto the arms of the bracket. For example, at least a section of the two arms of the bracket may be compressed via a dedicated press. In one embodiment, the press comprises an electrical, a mechanical, a hydraulic and/or a pneumatic drive. In a further embodiment, the press comprises two plates or blocks compressing the bracket from two different directions, particularly two opposing directions.

By compressing the bracket while the superconducting elements are positioned within two arms of the bracket, a superconducting joint between the bracket and the superconducting elements may be formed in a particularly simple and reproduceable manner. Thus, increased costs associated with more sophisticated machinery may favourably be avoided.

In one embodiment, the inventive method comprises the step of deforming the first superconducting element and/or the second superconducting element by applying pressure to provide a substantially planar surface on the first superconducting element and/or the second superconducting element according to an embodiment described above. Preferably, the step of removing material from a surface of the first superconducting element and/or a surface of the second superconducting element comprises removing material from the planar surface of the first superconducting element and/or the planar surface of the second superconducting element.

The inventive method shares the advantages of the inventive method for forming a superconducting joint between superconducting elements described above. Furthermore, in providing joining surfaces on opposing sides of the stack of superconducting elements, a process of bringing together the superconducting elements, deforming the superconducting elements and/or removing material from the superconducting elements may favourably be carried out without realigning or rearranging the superconducting elements between individual steps. Thus, the superconducting joints may be formed in a particularly time-efficient and/or cost-saving manner.

According to an embodiment of the inventive method, the compressing element comprises a bracket, wherein
- positioning the stack of superconducting elements between two walls of the compressing element comprises positioning the stack of superconducting elements between two arms of the bracket and wherein
- compressing the stack of superconducting elements between the two walls of the compressing element comprises compressing the stack of superconducting elements between the two arms of the bracket by bringing together the compressing element and a counter piece.

The counter piece preferably consists of a nonsuperconducting material. For example, the counter piece may comprise or consist of a metal, such as aluminium, steel, stainless steel, or the like. However, the counter piece may also comprise or consist of a plastic material, a ceramic material and/or a composite material.

The counter piece and the compressing element may comprise interlocking and/or complementary shapes according to an embodiment described above. Preferably, an outer dimension of a section of the compressing element is oversized with respect to an inner dimension of an opening of the counter piece in such a way, that the compressing element is itself compressed when positioned within the opening of the counter piece.

Bringing together the compressing element and the counter piece may comprise guiding the compressing element towards an opening of the counter piece. However, bringing together the compressing element and the counter piece may also comprise guiding the opening of the counter piece towards the compressing element or guiding the compressing element and the counter piece towards each other. Particularly, bringing together the compressing element and the counter piece may comprise joining the compressing element and the counter piece in a predefined relative position. The process of bringing together or joining the compressing element and the counter piece in a predefined relative position may be carried by exerting a force onto a surface of the counter piece and/or the compressing element.

According to a preferred embodiment of the inventive method,
- the stack of superconducting elements is held in a predefined position with respect to an opening of a counter piece when positioning the stack of superconducting elements between the two walls of the compressing element, wherein
- compressing the stack of superconducting elements between the two walls of the compressing element comprises wedging the stack of superconducting elements between the two walls of the compressing element by positioning the compressing element within an opening of the counter piece.

The counter piece may be shaped in such a way to maintain or support a predefined relative position of the stack of superconducting elements with respect to the counter piece while the compressing element is guided into the opening of the counter piece. For example, the opening of the counter piece may comprise a slot or notch configured to accommodate the compressing element. Thus, an undesirable movement of the stack of superconducting elements may favourably be reduced or prevented.

In a preferred embodiment, the compressing element may comprise a bracket with two walls or two arms. The stack of superconducting elements may be positioned or guided into a gap between the two arms of the bracket, when the compressing element is positioned within the opening of the counter piece.

By compressing the stack of superconducting elements between two walls of a bracket by positioning the compressing element within an opening of the counter piece, the superconducting joint may be formed in a simple and reproduceable manner. Thus, the inventive method may favourably be automatized or performed by less-trained personnel.

According to an embodiment of an inventive method, the superconducting elements are mechanically connected via a form-locking and/or force-locking connection when the stack of superconducting elements is positioned in a predefined relative position between the compressing element and the counter piece, and the compressing element and the counter piece are brought together.

As described above, the counter piece and the compressing element may comprise interlocking and/or complementary shapes, mechanically locking the stack of superconducting elements when guiding the compressing element into an opening of the counter piece. Thus, the superconducting elements may favourably be held in place between the counter piece and the compressing element as long as the compressing element and the counter piece remain in a joined state. For example, the compressing element and the counter piece may be secured or locked in the joined state via a securing element as described above.

It is also conceivable that the compressing element and the counter piece comprise complex 3D shapes configured to permanently deform or warp the stack of superconducting elements in such a way, that the counter piece and/or the compressing element can be removed without undoing the superconducting joint and/or the form-locking joint between the first superconducting element and the second superconducting element.

In connecting the first superconducting element and the second superconducting element via a form-locking and/or force locking connection, the superconducting joint between the first superconducting element and the second superconducting element may favourably be maintained, even when exposing the superconducting elements to strong electromagnetic forces associated with an operation of a magnetic resonance imaging device.

In a preferred embodiment of an inventive method, the counter piece and/or the compressing element is
- heated while compressing the stack of superconducting elements and/or
- pre-heated before compressing the stack of superconducting elements.

Preheating and/or heating the counter piece and/or the compression element may favourably render the stack of superconducting elements more pliable and decrease a pressure required to compress the stack of superconducting elements to form a superconducting joint.

It is also conceivable that heating the counter piece and/or the compression element improves a material bond formed between the first superconducting element and the second superconducting element when the stack of superconducting elements is compressed. For example, the stack of superconducting elements may be heated up to a maximum temperature of about 350 °C, 300 °C, or preferably 250 C°.

In one embodiment, preheating and/or heating of the counter piece and/or the compressing element may be achieved by running current through resistive wires embedded within the counter piece and/or compressing element. However, preheating of the counter piece and/or the compressing element may also be achieved by exposing the counter piece and/or the compressing element to high temperatures of up to 400 °C or less before compressing the stack of superconducting elements according to an embodiment described above.

The inventive superconducting magnet comprises a first superconducting element and a second superconducting element connected via a superconducting joint. The first superconducting element and the second superconducting element are held together by a compressing element and/or a counter piece along a section of the first superconducting element and the second superconducting element comprising the superconducting joint.

The superconducting magnet may be configured for use in a nuclear magnetic resonance spectrometer, a magnetic resonance imaging device, but also other devices, such as particle accelerators.

The compressing element and/or the counter piece may be implemented according to an embodiment described above. Preferably, the compressing element and the counter piece comprise interlocking and/or complementary shapes, securing the superconducting elements via a form-locking or force-locking connection when brought together according to an embodiment described above.

The compressing element and/or the counter piece may comprise or consist of a superconducting material. However, the counter piece and/or compressing element may also comprise or consist of a metal, a plastic, and/or a composite material.

The superconducting joint between the first superconducting element and the second superconducting element may be formed according to an embodiment described above. In particular, the superconducting joint between the first superconducting element and the second superconducting element may represent a mechanical connection devoid of lead and/or other substances usually associated with processes for forming superconducting joints.

The inventive superconducting magnet shares the advantages of an inventive method according to an embodiment described above. In particular, the inventive superconducting magnet may favourably be manufactured in less time and/or with less health risk or environmental damage in comparison to conventional superconducting magnets.

The inventive magnetic resonance imaging device comprises an inventive superconducting magnet with a first superconducting element and a second superconducting element connected via a superconducting joint according to an embodiment described above.

The inventive magnetic resonance imaging device shares the advantages associated with the inventive superconducting magnet according to an embodiment described above. Particularly, costs and/or health risks associated with the manufacturing of the inventive magnetic resonance imaging device may favourably be decreased in comparison to conventional magnetic resonance imaging devices.

The inventive manufacturing device is configured for jointing superconducting elements via an inventive method according to an embodiment described above. The inventive manufacturing device comprises a compressing unit configured for mechanically compressing the superconducting elements to form a superconducting joint.

In one embodiment, the compressing unit is configured for mechanically compressing the counter piece and the compressing element to form a superconducting joint between superconducting elements and/or between superconducting elements and the compression element.

The inventive manufacturing device may comprise one or more drives or drive assemblies configured for moving the counter piece and/or the compression element. The one or more drives or drive assembles may also be configured for aligning or arranging the superconducting elements relative to one another and/or relative to the counter piece and/or the compression element.

The drive or drive assembly may comprise a motor, such as an electrical motor, a combustion motor, a chemical motor, and the like. However, the drive or drive assembly may also be driven or actuated via a hydraulic system, a pneumatic system, an electrical actuator, a hydraulic actuator, a pneumatic actuator, a solenoidal actuator, a linear actuator, and the like.

Preferably, the inventive manufacturing comprises a processing unit and/or control unit configured to automatically perform individual steps or all steps of an inventive method according to an embodiment described above. The control unit may be configured to control one or more drives or drive assemblies to align and/or arrange the superconducting elements.

In particular, the control unit may be configured to control the one or more drives or drive assemblies to position the superconducting elements between the counter piece and the compressing element according to an embodiment described above. Furthermore, the control unit may be configured to control the one or more drives or drive assemblies to orient the first superconducting element and the second superconducting element in a predetermined relative position and/or bring the first superconducting element and the second superconducting element into contact according to an embodiment described above.

It is also conceivable that the control unit is configured to control the one or more drives or drive assemblies to bring together the compressing element and the counter piece. For example, the control unit may be configured to control the one or more drives or drive assemblies to guide the compressing element towards the counter piece and/or guide a section of the compressing into an opening of the counter piece according to an embodiment described above. The control unit may be configured to form the superconducting joint between the first superconducting element and the second superconducting element by controlling a relative motion and/or relative motion of the compressing element and the counter piece.

The inventive manufacturing device may favourably decrease costs and/or a lead-time per superconducting joint. Furthermore, the inventive manufacturing device may rely on mechanical compression of the superconducting elements to form a superconducting joint. Thus, the use of lead, acids or other substances which pose a threat to health or the environment may favourably be reduced or avoided. As a further advantage, the inventive manufacturing device may favourably allow less-skilled personnel to carry out and/or monitor the formation of superconducting joints according to an inventive method described herein.

According to an embodiment, the inventive manufacturing device further comprises a press configured for deforming a superconducting element and providing a planar surface on the superconducting element and/or a means for mechanically removing material from a surface of the superconducting element.

The press and/or the means for mechanically removing material from a surface of the superconducting elements may be controlled via a processing unit and/or control unit according to an embodiment described above.

In providing an inventive manufacturing device comprising a press and/or the means for mechanically removing material from a surface of the superconducting elements, all aspects of the inventive method may favourably be implemented in an automated manner and/or using just one device.

The inventive computer program product can be loaded into a memory of a programmable processing unit of a manufacturing device and comprises program code means to perform a method according to the invention when the computer program product is executed in the processing unit of the manufacturing device. As a result, the method according to the invention can be carried out quickly, and in a robust and repeatable manner. The computer program product is configured in such a way that it can carry out the method steps according to the invention by means of the processing unit. The processing unit must in each case comprise the prerequisites such as a corresponding main memory, a corresponding graphics card or a corresponding logic unit, so that the respective method steps can be carried out efficiently.

The computer program product is, for example, stored on a computer-readable medium or stored on a network, a server or a cloud, from where it can be loaded into the processor of a local processing unit. The local processing unit can be directly connected to the manufacturing device or designed as part of the manufacturing device. Furthermore, control information of the computer program product can be stored on an electronically readable medium. The control information on the electronically readable medium can be designed in such a way that, when the medium is used, it carries out a method according to the invention in a processing unit of the manufacturing device. Examples of an electronically readable medium are a DVD, a magnetic tape or a USB stick on which electronically readable control information, in particular software, is stored. If this control information is read from the medium and stored in a control and/or processing unit of a manufacturing device, all embodiments of the inventive method described above can be carried out.

Further advantages and details of the present invention may be recognized from the embodiments described below as well as the drawings. The figures show:
- Fig. 1: a schematic representation of an embodiment of an inventive magnetic resonance imaging device,
- Fig. 2: a flow chart of an embodiment of an inventive method,
- Fig. 3: a flow chart of an embodiment of an inventive method,
- Fig. 4: a superconducting element according to a step of an inventive method,
- Fig. 5: a superconducting element according to a step of an inventive method,
- Fig. 6: a superconducting element according to a step of an inventive method,
- Fig. 7: an embodiment of an inventive stack of superconducting elements,
- Fig. 8: an embodiment of an inventive stack of superconducting elements,
- Fig. 9: an embodiment of an inventive compressing element and an inventive counter piece,
- Fig. 10: an embodiment of an inventive compressing element and an inventive counter piece,
- Fig. 11: an embodiment of an inventive compressing element and an inventive counter piece,
- Fig. 12: an embodiment of an inventive compressing element and an inventive counter piece,
- Fig. 13: an embodiment of an inventive compressing element and an inventive counter piece,
- Fig. 14: an embodiment of an inventive compressing element and an inventive counter piece,
- Fig. 15: an embodiment of an inventive stack of superconducting elements,
- Fig. 16: an embodiment of an inventive compressing element and an inventive counter piece,
- Fig. 17: an embodiment of an inventive compressing element and an inventive counter piece,
- Fig. 18: an embodiment of an inventive manufacturing device.

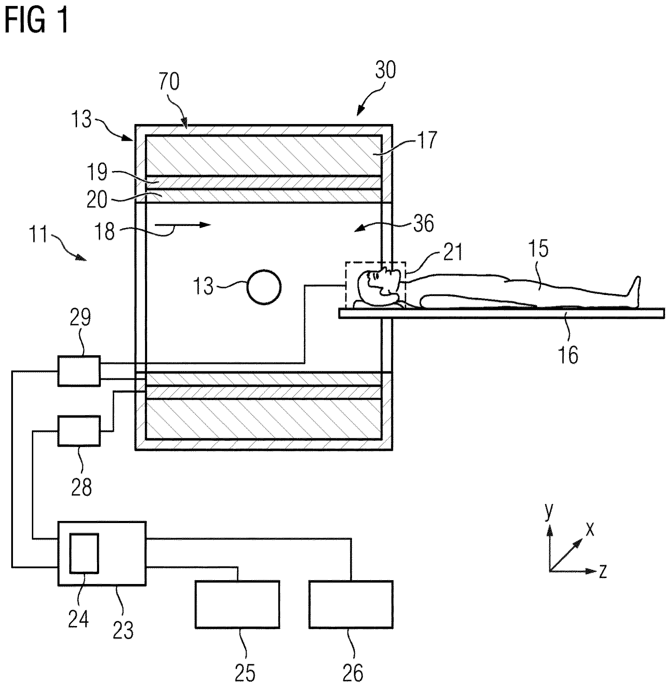

Fig. 1 shows an embodiment of a magnetic resonance imaging device 11 according to the invention. The magnetic resonance imaging device 11 comprises a field generation unit 30 including a cylindrical magnet 17 that provides a homogenous, static magnetic field 18 (B0 field). The static magnetic field 18 comprises an isocentre 13 and a cylindrical imaging region 36 for receiving an imaging object, such as a patient 15. The imaging region 36 may be defined by a bore configured for accommodating a patient 15 during a magnetic resonance measurement. The imaging region 36 is surrounded or enclosed by the field generation unit 30 in a circumferential direction.

In the depicted example, the magnetic resonance imaging device 11 comprises a patient support 16 configured for transporting the patient 15 into the imaging region 36. In particular, the patient support 16 may be configured to transport a diagnostically relevant region of the patient 15 into the isocentre 13 of the magnetic resonance imaging device 11.

The magnetic resonance imaging device 11 further comprises a gradient system 19 configured for providing magnetic gradient fields used for spatial encoding of magnetic resonance signals acquired during a magnetic resonance measurement. The gradient system 19 is activated or controlled by a gradient controller 28 via an appropriate current signal. It is conceivable that the gradient system 19 comprises one or more gradient coils for generating magnetic gradient fields in different, preferably orthogonally oriented, spatial directions.

The magnetic resonance imaging device 11 may comprise a high frequency system including a radiofrequency antenna 20 (i. e. a body coil), which may be integrated into the magnetic resonance imaging device 11. The radiofrequency antenna 20 is operated via a radiofrequency controller 29 that controls the radiofrequency antenna 20 to generate a high frequency magnetic field and emit radiofrequency excitation pulses into the imaging region 36. The magnetic resonance imaging device 11 may further comprise a local coil 21, which is positioned on or in proximity to the diagnostically relevant region of the patient 15. The local coil 21 may be configured to emit radiofrequency excitation pulses into the patient 15 and/or receive magnetic resonance signals from the patient 15. It is conceivable, that the local coil 21 is controlled via the radiofrequency controller 29.

The magnetic resonance imaging device 11 may further comprise a control unit 23 configured for controlling the magnetic resonance imaging device 11. The control unit 23 may include a processing unit 24 configured for processing magnetic resonance signals and reconstructing magnetic resonance images. The processing unit 24 may also be configured to process input from a user of the magnetic resonance imaging device 11 and/or provide an output to the user. For this purpose, the processing unit 24 and/or the control unit 23 can be connected to a display unit 25 and an input unit 26 via a suitable signal connection. For a preparation of a magnetic resonance imaging measurement, preparatory information, such as imaging parameters or patient information, can be provided to the user via the display unit 25. The input unit 26 may be configured to receive information and/or imaging parameters from the user.

The cylindrical magnet 17 shown in Fig. 1 represents an inventive superconducting magnet including two or more inventive superconducting elements. The superconducting elements are connected via superconducting joints according to an embodiment described herein.

The magnetic resonance imaging device 11 may comprise further components that magnetic resonance imaging devices usually possess. The general operation of a magnetic resonance imaging device 11 is known to those skilled in the art. Therefore, a more detailed description is omitted.

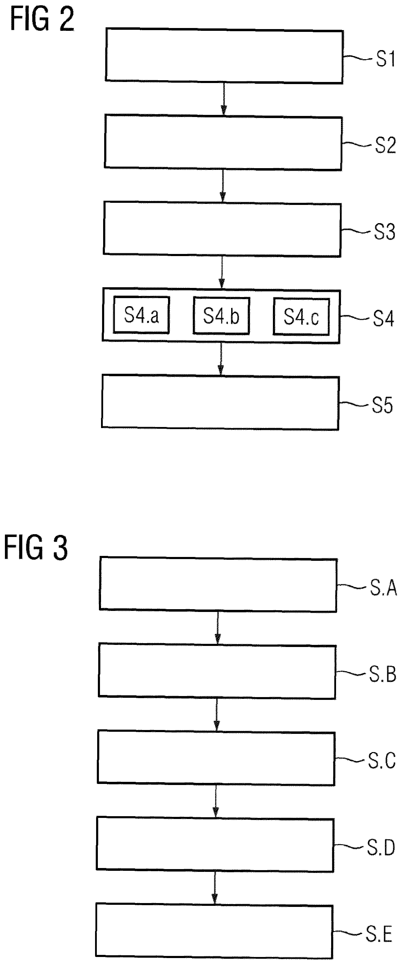

Fig. 2 shows a flow chart of an inventive method for forming a superconducting joint between superconducting elements.

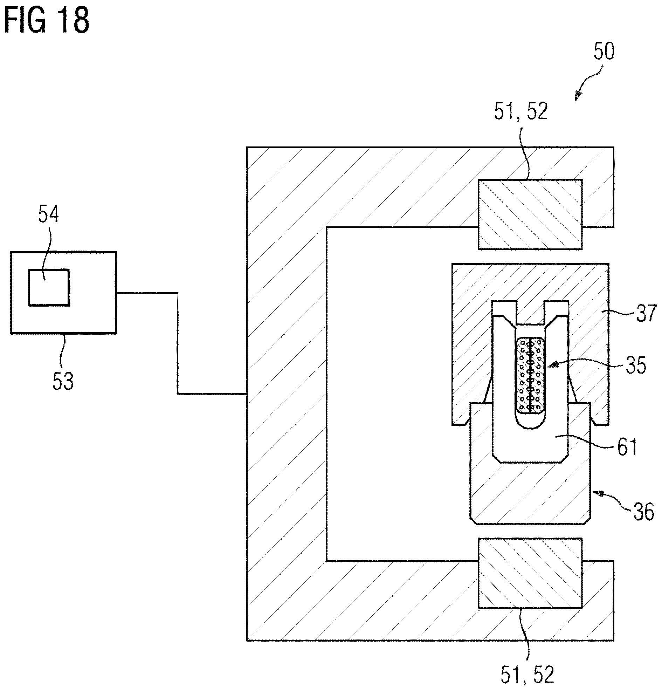

In an optional step S1, a first superconducting element 30a is deformed by applying pressure to provide a substantially planar surface 31 on the first superconducting element 30a. Preferably, the first superconducting element is deformed via a mechanical press, a platen, or the like. The optional step S1 may be carried out by an inventive manufacturing device 50 as depicted in Fig. 18.

In a step S2, material is removed from a surface of the first superconducting element 30a to expose a filament 33 of the first superconducting element 30a and provide a joining surface 32. The material is removed from the first surface of the superconducting element 30a in a mechanical process, such as a grinding, a cutting and/or a milling process.

In a preferred embodiment, the first superconducting element 30a is deformed according to step S1 to provide a substantially planar surface 31 on the first superconducting element 30a before material is removed from the planar surface 31 of the first superconducting element 30a according to step S2.

According to a further step S3, the first superconducting element 30a and a second superconducting element 30b are oriented in such a way, that the joining surface 32a of the first superconducting element 30a is oriented towards a joining surface 32b of the second superconducting element 30b. The joining surface 32a of the first superconducting element 30a and the joining surface 32b of the second superconducting element 30b are then brought into contact to form a stack of superconducting elements 35.

In an optional step S4.a, the stack of superconducting elements 35 is positioned in a predefined relative position between a compressing element 36 and a counter piece 37. The positioning or arranging of the position of the stack of superconducting elements 35 may be performed manually by a technician or automatically by the inventive manufacturing device 50.

In one embodiment, the compressing element 36 comprises a pin and the stack of superconducting elements 35 is formed onto the pin in an optional step S4.b.

In an alternative embodiment, the compressing element 36 comprises a bracket 61 and the stack of superconducting elements 35 is positioned between two arms of the bracket 61 in an optional step S4.c.

In a step S5, the stack of superconducting elements 35 is compressed to form the superconducting joint between the superconducting elements. Depending on a mechanical implementation of the inventive manufacturing device 50, compressing the stack of superconducting elements 35 may comprise:
- wedging the stack of superconducting elements 35 between the counter piece 37 and the compressing element 36 by bringing together the compressing element 36 and the counter piece 37,
- wedging the stack of superconducting elements 35 between a wall of an inner bore 42 of the counter piece 37 and the pin 41 by positioning the pin 41 within the inner bore 42 of the counter piece 37, or
- wedging the stack of superconducting elements 35 between two walls of the bracket by positioning the bracket within an opening of the counter piece 37.

Fig. 3 shows a schematic flow chart of an alternative method for forming a superconducting joint between superconducting elements 30 and a compressing element 36.

In a step S.B, material is removed from a first surface of a first superconducting element 30a and from a second surface of a second superconducting element 30b to expose filaments 33 of the first superconducting element 30a and of the second superconducting element 30b and provide a first joining surface 32a on the first superconducting element 30a and a second joining surface 32b on the second superconducting element 30b. For removing of material, one of the mechanical processes described above may be used. Preferably, the step S.B is carried out by the inventive manufacturing device 50.

In a further step S.C, the first superconducting element 30a and the second superconducting element 30b are oriented in such a way, that the first surface and the second surface are facing in opposite directions. The first superconducting element 30a and the second superconducting element 30b are brought into contact to form a stack of superconducting elements 35. The step S.C may be carried out manually or automatically, i. e. via the inventive manufacturing device 50.

In a preferred embodiment, the step S.C is carried out before the step S.B. For example, the stack of superconducting elements 35 may be arranged within an inventive manufacturing device 50 in step S.C. The inventive manufacturing device 50 may comprise at least two grinders arranged in such a way, that material can be removed synchronously from the first surface of the first superconducting element 30a and from the second surface of a second superconducting element 30b facing outwards from the stack of superconducting elements 35. Thus, the inventive method may be carried out in a particular time-efficient manner.

It is conceivable, that the inventive method comprises the optional step S.A, wherein the first superconducting element 30a or the stack of superconducting elements 35 is deformed by applying pressure to provide a substantially planar surface 31 on the first superconducting element 30a or the stack of superconducting elements 35. Preferably, the optional step S.A is performed before the step S.B and after the step S.C.

According to a further step S.D, the stack of superconducting elements 35 is positioned between two walls of a compressing element 36, wherein the first joining surface 32a is oriented towards a first wall of the compressing element 36 and the second joining surface 32b is oriented towards a second wall of the compressing element 36. As described above, positioning the stack of superconducting elements 35 may be carried out manually by a technician or automatically, i. e. by the inventive manufacturing device 50.

In one embodiment, the compressing element 36 comprises a bracket and the stack of superconducting elements 35 is positioned between two arms of the bracket.

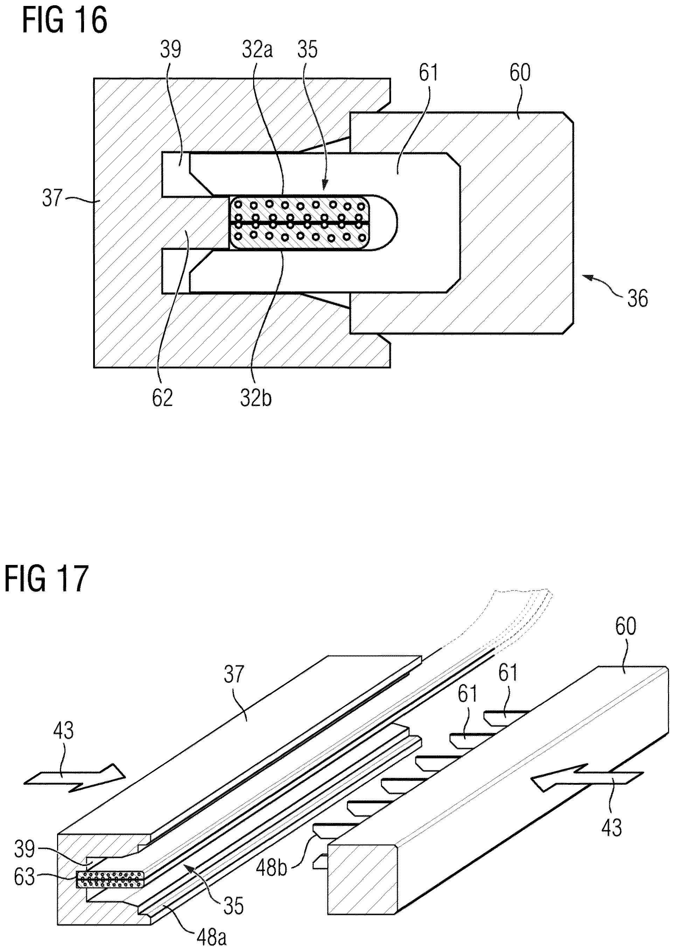

In a further embodiment, the stack of superconducting elements 35 is held in a predefined position with respect to an opening 39 of the counter piece 37 when positioning the stack of superconducting elements 35 between the two walls of the compressing element 36 (see Figs. 16 and 17).

In a step S.E, the stack of superconducting elements 35 is compressed between the two walls of the compressing element 36 to form the superconducting joint between the superconducting elements 30 and the compressing element 36.

In different embodiments of the inventive method, the step S.E may comprise:
- compressing the stack of superconducting elements 35 between the two arms of the bracket and/or
- wedging the stack of superconducting elements 35 between the two walls of the compressing element 36 by positioning the compressing element 36 within the opening 39 of the counter piece 37.

According to an embodiment of an inventive method, the superconducting elements 30 form a form-locking and/or force-locking connection with the compressing element 36 and/or the counter piece 37 when the stack of superconducting elements 35 is positioned in a predefined relative position between the compressing element 36 and the counter piece 37, and the compressing element 36 and the counter piece 37 are brought together.

In a preferred embodiment of an inventive method, the counter piece 37 and/or the compressing element 36 is
- heated while compressing the stack of superconducting elements 35 and/or
- pre-heated before compressing the stack of superconducting elements 35
in the step S5 or the step S.E. When the superconducting elements 30 cool down, additional compression may be generated due to different contraction rates of the counter piece 37 and the compression element 36. For example, the inventive manufacturing device 50 may comprise a heating unit configured to heat and/or pre-heat the counter piece 37 and/or the compressing element 36 according to an embodiment described above.

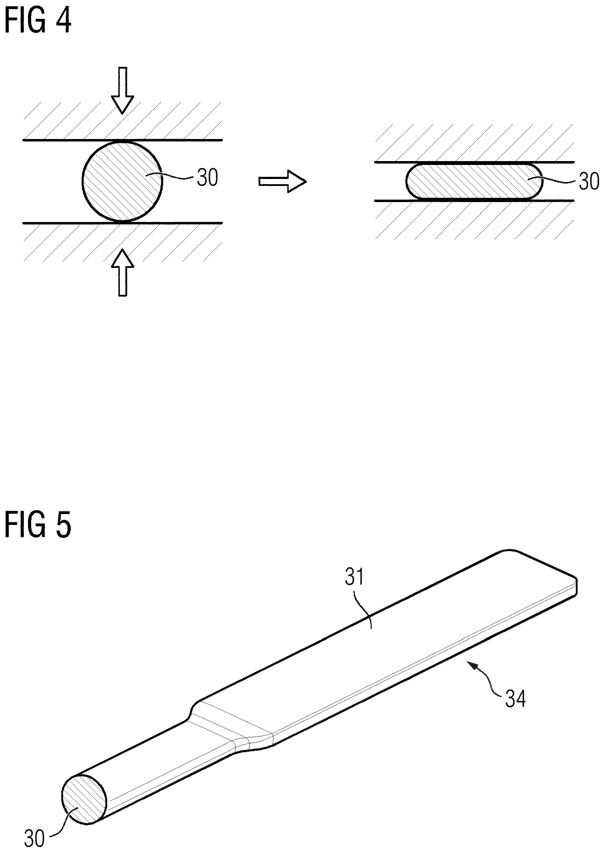

Fig. 4 depicts a superconducting element 30 which is mechanically deformed between two plates of a press in a step S1 or a step S.A of an inventive method. The superconducting element 30 may initially comprise an oval cross-section, but also a rectangular or polygonal cross-section. After pressing the superconducting element 30 between the two plates, the cross-section of the superconducting element 30 may comprise a rectangular shape, a pill-shape, or a rod shape as illustrated in Fig. 3.

According to an embodiment, the steps S1 and S.A comprise deforming the stack of superconducting elements 35 instead of a single superconducting element 30.

Fig. 5 depicts an end piece 34 of a superconducting element 30 which has been mechanically deformed as described above. The end piece 34 of the superconducting element 30 comprises a planar surface 31 which may be processed in a further step S2 or S.B to expose the filaments 33 of the superconducting element 30.

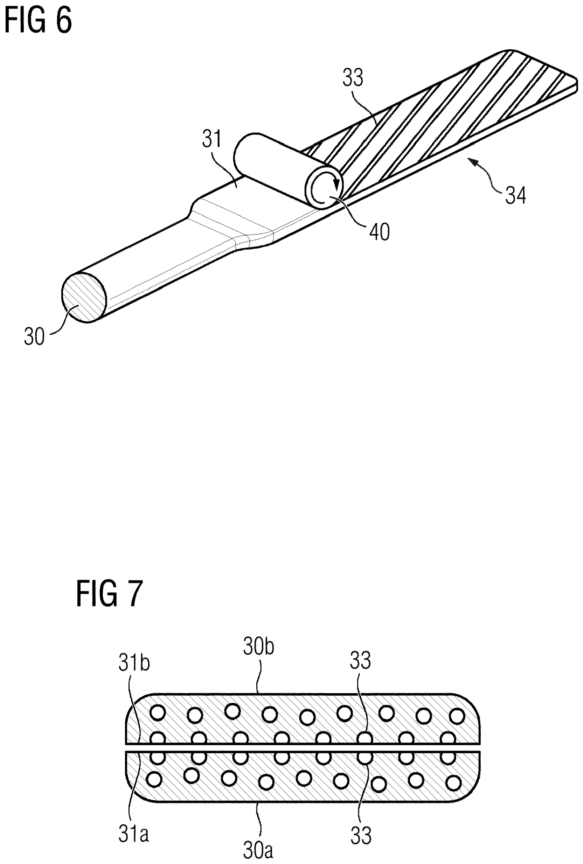

In Fig. 6, a process of removing material, particularly copper or a copper alloy, from the planar surface 31 of the superconducting element 30 according to a step S2 or S.B of an inventive method is shown. In the depicted embodiment, a grinding wheel 40 is used to remove the copper from the planar surface 31 and expose the filaments 33 of the superconducting element 30.

Fig. 7 shows an embodiment of a stack of superconducting elements 35. The stack of superconducting elements 35 may be provided by orienting a first superconducting element 30a and a second superconducting element 30b in such a way, that the joining surface 31a of the first superconducting element 30a is oriented towards a joining surface 31b of the second superconducting element 30b. The joining surface 31a of the first superconducting element 30a and the joining surface 31b of the second superconducting element 30b may be brought into contact according to the step S3 or the step S.C of an inventive method.

Preferably, the first superconducting element 30a and the second superconducting element 30b are oriented and/or processed in such a way, that the exposed filaments of the first superconducting element 30a and the superconducting element 30b cross each other, when the first superconducting element 30a and the second superconducting element 30b are brought together according to the steps S3 or S.C of an inventive method. For example, a direction of removing material from the first surface 31a of the first superconducting element 30a and the second surface 31b of the second superconducting element 30b may differ. Thus, a direction of grinding marks on the first surface 31a and the second surface 31b may differ. Preferably, the filaments within the superconducting elements 30 are wound in a spiral. Thus, the exposed filaments on a joining surface 32 of a superconducting element 30 may exhibit an orientation determined by a winding pattern of the filaments.

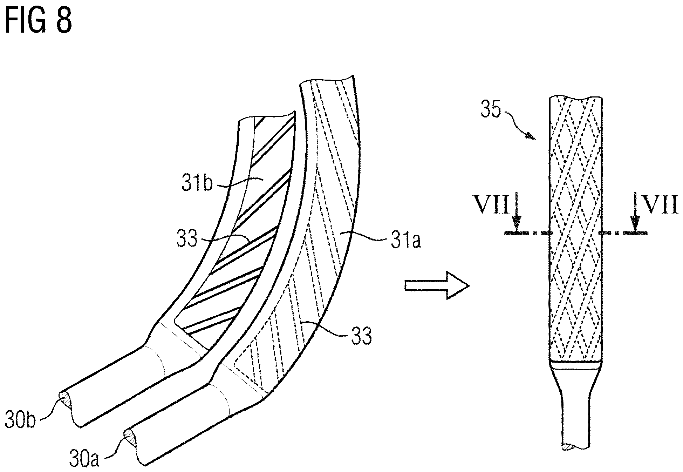

Fig. 8 illustrates how the first superconducting element 30a and the second superconducting element 30b are oriented and brought together in such a way, that the orientation of the exposed filaments 33 on the first joining surface 32a crosses or intersects the orientation of exposed filaments 33 on the joining surfaces 32b. Thus, a particularly effective superconducting joint may be formed when compressing the stack of superconducting elements 35.

The embodiment of the stack of superconducting elements 35 depicted in Fig. 7 may represent a cross-sectional view along the plane B-B of the stack of superconducting elements 35 as shown in Fig. 8.

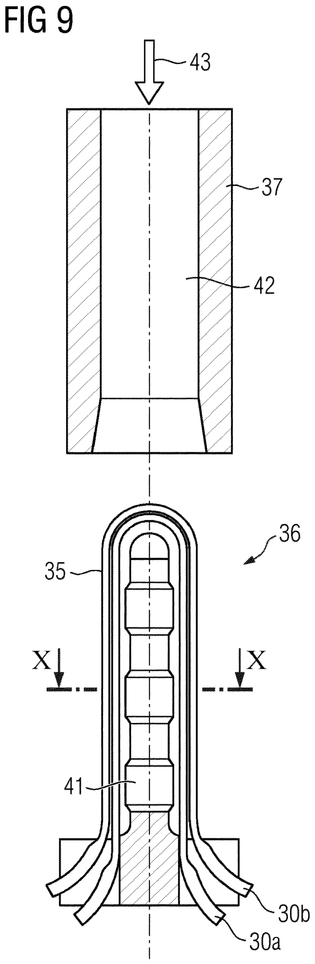

Fig. 9 illustrates embodiments of a counter piece 37 and a compression element 36. The compression element 36 comprises a pin 41 or spigot. Preferably, the pin 41 is made of stainless steel. The pin 41 may comprise raised rings distributed along an outer circumference of a shaft of the pin 41. However, the pin 41 may also have a plain shaft.

The counter piece 37 comprises a collar or sleeve with an inner bore 42. Preferably, the counter piece 37 is made of a metal, such as aluminium, an aluminium alloy, steel or stainless steel.

The stack of superconducting elements 35 may be formed onto, wound around and/or looped over the pin 41 according to the steps S4.a, S4.b and/or S4.c described above.

In order to form a superconducting joint between the firs superconducting element 30a and the second superconducting element 30b, the counter piece 37 and the compression element 36 may be brought together or pushed together as indicated by arrow 43, thus mechanically compressing or wedging the stack of superconducting elements 35 between the counter piece 37 and the compression element 36. For example, the pin 41 may be guided into the inner bore 42 of the counter piece 37. Alternatively, the counter piece 37 may be guided over the shaft of the pin 41 or the counter piece 37 and the compression element 36 may be guided towards each other.

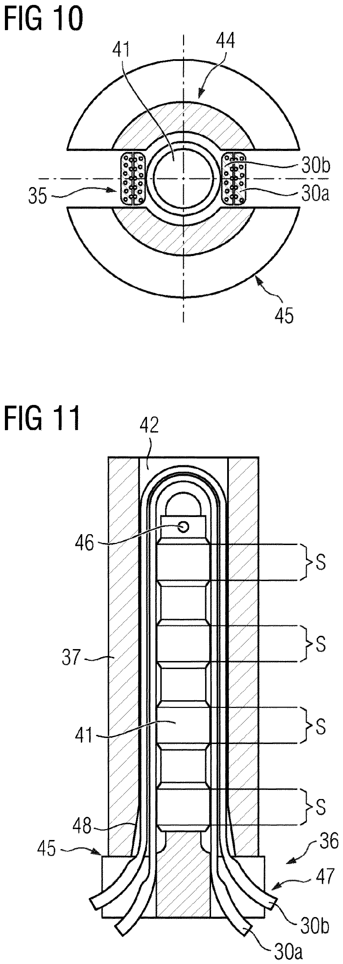

Fig. 10 depicts a bottom view of an embodiment of the compression element 36 shown in Fig. 8. The compression element 36 may comprise a base 45, the pin 41 as well as guide blocks 44. The guide blocks 44 may facilitate forming the stack of superconducting elements 35 onto the pin 41 and/or prevent excessive movement of the stack of superconducting elements 35 relative to the pin 41.

Fig. 11 depicts an embodiment, wherein the compressing element 36 is positioned within the inner bore 42 of the counter piece 37, thus compressing the stack of superconducting elements 35 and forming a superconducting joint between the first superconducting element 30a and the second superconducting element 30b.

In the depicted example, the pin 41 of the compressing element 36 has raised rings. The raised rings may be distributed in regular or irregular intervals along the shaft of the pin 41. In particular, the superconducting joints may be formed at the sections S along the shaft comprising the raised rings.

In one embodiment, the pin 41 may comprise a hole 46 configured for accommodating a securing pin (not shown). Thus, the pin 41 may favourably be secured within the inner bore 42 of the counter piece 37.

The superconducting elements 30 or wires may be cut at an end 47. At an opposite end of the superconducting joint, the superconducting elements 30a and 30b are preferably connected to a superconducting coil or a superconducting magnet 17 as illustrated in Fig. 1. In accordance with Fig. 10, the superconducting elements 30a and 30b may be routed through the base 45 of the compressing element 36 via channels or notches between the guide blocks 44 (see Fig. 10).

The sleeve or collar of the counter piece 37 may comprise a chamfered inlet 48 configured for facilitating the process of guiding and/or pushing the counter piece 37 over the compressing element 36.

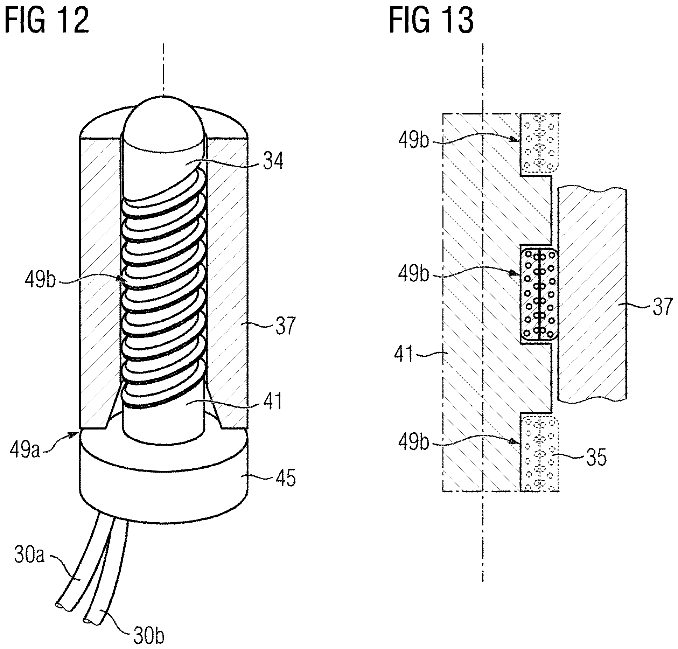

Fig. 12 shows further embodiments of the compressing element 36 and the counter piece 37. In the depicted example, the pin 41 of the compressing element 36 comprises a groove 49b, particularly a spiral groove 49b, wherein the superconducting elements 30a and 30b are routed (see Fig. 13). The base 45 of the compressing element 36 may also comprise a groove 49a, wherein the superconducting elements 30a and 30b are routed and guided into the spiral groove 49b on the pin 41.

In one embodiment, the superconducting elements 30a and 30b are wound in such a way, that end pieces 34 of the superconducting elements 30a and 30b are positioned at a top or pinnacle of the pin 41. However, other winding schemes of the superconducting elements 30 are of course conceivable.

Sections of the superconducting elements 30a and 30b leaving the base 45 are connected to a superconducting coil or a superconducting magnet 17 as described above.

Fig. 13 shows a cross-sectional view of a superconducting joint according to the embodiment depicted in Fig. 12. The stack of superconducting elements 35 is positioned within the groove 49b. The stack of superconducting elements 35 is wedged between the shaft of the pin 41 and the counter piece 37 when the counter piece 37 is guided or pushed over the pin 41. Thus, the stack of superconducting elements 35 is compressed and a superconducting joint is formed between the joining surfaces 32a and 32b of the superconducting elements 30a and 30b.

In the depicted example, the counter piece 37 is preferably embodied as a sleeve or collar made of aluminium.

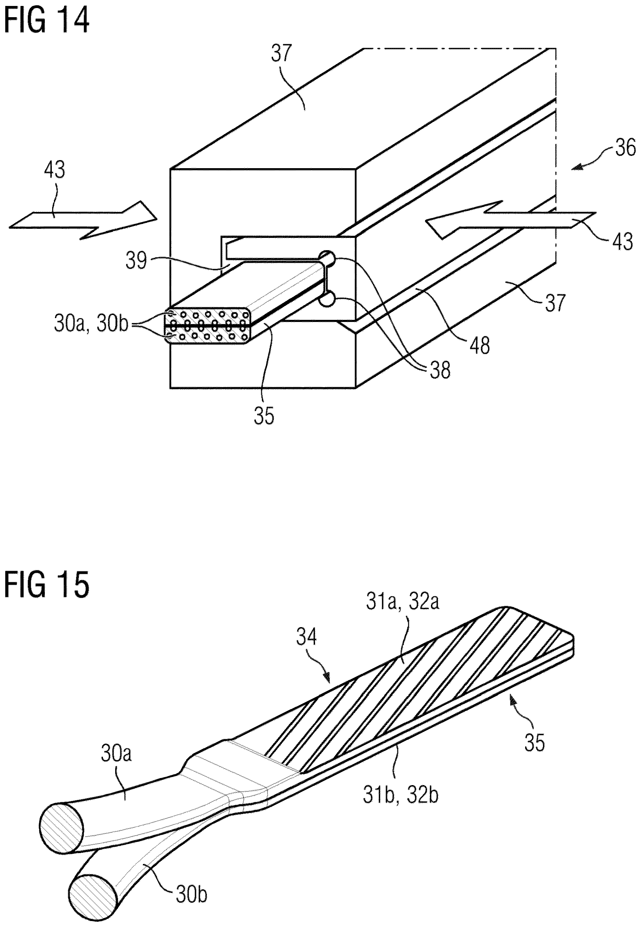

Fig. 14 shows a superconducting joint formed via an inventive method as described above. In the depicted example, the compressing element 36 is formed as a bracket or a clamp configured to encompass the joining surfaces 32a and 32b of the stack of superconducting elements 35.

The compressing element 36 has two walls or arms confining the stack of superconducting elements 35 from two opposite directions. In the depicted embodiment, the compressing element 36 comprises one or more hinges 38 configured for opening a wall of the compressing element 36 and facilitate the step of positioning S.4c the stack of superconducting elements 35 between the two walls of the compressing element 36.

Preferably, the compressing element 36 is made of copper. However, the bracket may also represent a section of the compressing element 36 made of copper, i. e. extruded copper.

The forming of the superconducting joint between the superconducting elements 30a and 30b may be carried out by guiding or pushing the compressing element 36 carrying the stack of superconducting elements 35 into the opening 39 or the slot of the counter piece 37. The counter piece 37 and/or the compression element 36 may comprise chamfered inlets 48 or chamfered edges to facilitate a process of guiding the bracket into the opening 39 or slot of the counter piece 37.

The counter piece 37 may be a simple block made of aluminium or steel. In the depicted example, the block has a cuboid shape, however, the block may have any suitable shape. The opening 39 or slot in the counter piece 37 may be slightly undersized with respect to a distance between outer surfaces of the two walls or arms of the bracket. Thus, the stack of superconducting elements 35 is compressed between the two walls or arms of the bracket when the compressing element 36 and the counter piece 37 are brought together as indicated by arrows 43. In the shown example, the superconducting joint is formed between the joining surfaces 32a and 32b of the superconducting elements 30a and 30b which are oriented towards one another (see Fig. 7). However, the superconducting joint may also be formed between the joining surfaces 32a and 32b of the superconducting elements 30a and 30b and the compression element 36 as described below.

In the embodiment illustrated in Fig. 15, the first superconducting element 30a and the second superconducting element 30b forming the stack of superconducting elements 35 are oriented (see step S.C) in such a way, that the joining surface 32a and the joining surface 32b are facing in opposite directions. Preferably, the stack of superconducting elements 35 is used in an inventive method, wherein the superconducting joint is formed between the superconducting elements 30 and the compressing element 36 (see Figs. 16 to 17).

As described above, the superconducting elements 30a and 30b may be deformed (see steps S1 or S.A) individually or as a stack of superconducting elements 35 to provide planar surfaces 31a and 31b on the superconducting elements 30a and 30b. Likewise, the step of removing material S.B may be applied to individual superconducting elements 30 or to a stack of superconducting elements 35. In the latter case, material may simultaneously be removed from the planar surfaces 31a and 31b to expose the filaments of the superconducting elements 30a and 30b and provide the joining surfaces 32a and 32b.

Fig. 16 shows an embodiment, wherein the superconducting joint is formed between the superconducting elements 30 and the compressing element 36.

As illustrated in Fig. 16, the compressing element 36 may comprise a bracket or clamp similar in shape to the one depicted in Fig. 14. However, in the example shown in Fig. 16, the bracket is made of a superconducting material, such as NbTi. The compressing element 36 may comprise a single bracket or multiple brackets distributed in regular or irregular intervals along a length of the compressing element 36 (see Fig. 17). The compressing element 36 may further comprise a retainer 60 configured for holding or carrying the bracket. The retainer may be made of a metal, such as aluminium or preferably steel or stainless steel. However, the retainer may also be made of other materials, such as plastic or a composite material. The bracket may be mechanically connected to the retainer 60 via a form-locking connection, a force-locking connection and/or a material bond (i. e. via an adhesive). Preferably, the bracket is embedded within the retainer 60 as depicted in Fig. 16.

As shown in Fig. 16, the opening 39 of the counter piece 37 may comprise a protrusion 62 configured for retaining the stack of superconducting elements 35 between the two arms of the bracket 61 and/or add to the compression of the stack of superconducting elements 35 when compressing the stack of superconducting elements 35. The protrusion 62 may be embodied in such a way, that it fits in a gap between the two arms of the bracket 61 when bringing together the compressing element 36 and the counter piece 37 according to the step S.E.

Fig. 17 depicts a further embodiment of a compressing element 36 and a counter piece 37.

In the illustrated example, a plurality of brackets 61 or blades is held by the retainer 60 of the compressing element 36. In contrast to the embodiment depicted in Fig. 16, the stack of superconducting elements 35 is held in a slot or recess 63 within the opening 39 of the counter piece 37, when the compressing element 36 and the counter piece 37 are brought together as indicated by arrows 43.

Preferably, the counter piece 37, but also the retainer 60, are made of a metal or a plastic. However, other materials mentioned above are conceivable as well. The counter piece 37 and/or the plurality of brackets 61 may comprise chamfered or phased inlets and/or edges 48a and 48b configured to facilitate accommodation of the compressing element 36 within the opening of the counter piece 37 and/or accommodation of the stack of superconducting elements 35 between the arms of the plurality of blades 61.

Fig. 18 shows an embodiment of an inventive manufacturing device 50 configured for joining superconducting elements 30 according to an inventive method. The manufacturing device 50 comprises a compressing unit 51 configured for mechanically compressing the counter piece 37 and the compressing element 36 to form a superconducting joint between two superconducting elements 30 and/or between two superconducting elements 30 and the compression element 36.

Preferably, the manufacturing device comprises a control unit 53 including a processing unit 54 configured for automatically carrying out one or more steps of an inventive method according to an embodiment described above. A computer program product may be loaded into a memory of a programmable processing unit 54 of the manufacturing device 50. The computer program product may comprise program code means to perform an inventive method according to an embodiment described above when the computer program product is executed in the processing unit 54 of the manufacturing device 50.

In one embodiment, a compressing unit 51 of the manufacturing device 50 is configured for bringing together the counter piece 37 and the compressing element 36 according to a step S.E and/or a step S5. However, the compressing unit 51 may also be configured to act as a mechanical press configured for deforming a superconducting element 30 according to the step S1 and/or the step S.A. Particularly, the compressing unit 51 may be implement as a mechanical press.

It is also conceivable that the manufacturing device 50 comprises a means for mechanically removing material from a surface of the superconducting elements 30 and configured to carry out the step S.B and/or the step S2. For example, the manufacturing device 50 may comprise a milling unit 52, a grinding unit 52 and/or a cutting unit 52.

Furthermore, the manufacturing device 50 may comprise means (not shown) for orienting, aligning and/or arranging at least one superconducting element 30 according to the step S3 and/or S.C of an inventive method described above.

The embodiments described above are to be recognized as examples. It is to be understood that individual embodiments may be extended by or combined with features of other embodiments if not stated otherwise.

In particular, the steps of the inventive methods described herein may be performed in a different order as described herein without departing from the invention described herein.

## Claims

1. A method for forming a superconducting joint between superconducting elements (30) comprising the steps:
• removing (S2) material from a surface of a first superconducting element (30a) to expose a filament (35) of the first superconducting element (30a) and provide a joining surface (32),
• orienting (S3) the first superconducting element (30a) and a second superconducting element (30b) in such a way, that the joining surface (32) of the first superconducting element (30a) is oriented towards a joining surface (32) of the second superconducting element (30b), and bringing into contact the joining surface of the first superconducting element (30a) and the joining surface of the second superconducting element (30b) to form a stack of superconducting elements (35),
• compressing (S5) the stack of superconducting elements (35) to form the superconducting joint between the superconducting elements (30).

2. The method according to claim 1, wherein removing (S2) material from the surface of the first superconducting element (30a) comprises mechanically removing material, preferably via a grinding, cutting and/or milling process.

3. The method according to one of the claims 1 or 2, further comprising the step:
• positioning (S4.a) the stack of superconducting elements (35) in a predefined relative position between a compressing element (36) and a counter piece (37),
wherein compressing (S5) the stack of superconducting elements (35) comprises wedging the stack of superconducting elements (35) between the counter piece (37) and the compressing element (36) by bringing together the compressing element (36) and the counter piece (37).

4. The method according to claim 3, wherein the counter piece (37) comprises an inner bore (42) and the compressing element (36) comprises a pin (41), wherein the method for forming a superconducting joint between superconducting elements (30) comprises the further step of:
• forming (S4.b) the stack of superconducting elements (35) onto the pin (41),
wherein compressing (S5) the stack of superconducting elements (35) comprises wedging the stack of superconducting elements (35) between a wall of the inner bore (42) of the counter piece (37) and the pin (41) by positioning the pin (41) within the inner bore (42) of the counter piece (37).

5. The method according to claim 3, wherein the counter piece (37) comprises an opening (39) and the compressing element (36) comprises a bracket (61) and wherein the method for forming a superconducting joint between superconducting elements (30) comprises the step:
• positioning (S4.c) the stack of superconducting elements (35) between two arms of the bracket (61),
wherein compressing (S5) the stack of superconducting elements (35) comprises wedging the stack of superconducting elements (35) between the two arms of the bracket (61) by positioning the bracket (61) within the opening (39) of the counter piece (37).

6. A method for forming a superconducting joint between superconducting elements (30) and a compressing element (36) comprising the steps:
• removing (S.B) material from a first surface of a first superconducting element (30a) and from a second surface of a second superconducting element (30b) to expose filaments (35) of the first superconducting element (30a) and of the second superconducting element (30b) and provide a first joining surface (32) on the first superconducting element (30a) and a second joining surface (32) on the second superconducting element (30b),
• orienting (S.C) the first superconducting element (30a) and the second superconducting element (30b) in such a way, that the first surface and the second surface are facing in opposite directions and bringing into contact the first superconducting element (30a) and the second superconducting element (30b) to form a stack of superconducting elements (35),
• positioning (S.D) the stack of superconducting elements (35) between two walls of a compressing element (36), wherein the first joining surface (32) is oriented towards a first wall of the compressing element (36) and the second joining surface (32) is oriented towards a second wall of the compressing element (36), and
• compressing (S.E) the stack of superconducting elements (35) between the two walls of the compressing element (36) to form the superconducting joint between the superconducting elements (30) and the compressing element (36).

7. The method according to claim 6, wherein the compressing element (36) comprises a bracket (61) and wherein
• positioning (S.D) the stack of superconducting elements (35) between two walls of the compressing element (36) comprises positioning the stack of superconducting elements (35) between two arms of the bracket (61), wherein
• compressing (S.E) the stack of superconducting elements (35) between the two walls of the compressing element (36) comprises compressing the stack of superconducting elements (35) between the two arms of the bracket (61) by bringing together the compressing element (36) and a counter piece (37).

8. The method according to one of the claims 6 or 7, wherein
• the stack of superconducting elements (35) is held in a predefined position with respect to an opening (39) of a counter piece (37) when positioning (S.D) the stack of superconducting elements (35) between the two walls of the compressing element (36) and wherein
• compressing (S.E) the stack of superconducting elements (35) between the two walls of the compressing element (36) comprises wedging the stack of superconducting elements (35) between the two walls of the compressing element (36) by positioning the compressing element (36) within the opening (39) of the counter piece (37).

9. The method according to one of the claims 3 to 5 or 7 to 8, wherein the superconducting elements (30) are mechanically connected via a form-locking and/or force-locking connection when the stack of superconducting elements (35) is positioned in a predefined relative position between the compressing element (36) and the counter piece (37), and the compressing element (36) and the counter piece (37) are brought together.

10. The method according to one of the claims 3 to 5 or 7 to 9, wherein the counter piece (37) and/or the compressing element (36) is
• heated while compressing (S5, S.E) the stack of superconducting elements (35) and/or
• pre-heated before compressing (S5, S.E) the stack of superconducting elements (35).

11. The method according to one of the preceding claims, further comprising the step:
• deforming (S1, S.A) the first superconducting element (30a) by applying pressure to provide a substantially planar surface (31) on the first superconducting element (30a),
wherein removing (S2, S.B) material from a surface of the first superconducting element (30a) comprises removing material from the planar surface (31) of the first superconducting element (30a).

12. A superconducting magnet comprising a first superconducting element (30a) and a second superconducting element (30b) connected via a superconducting joint, wherein the first superconducting element (30a) and the second superconducting element (30b) are held together by a compressing element (36) and/or a counter piece (37) along a section of the first superconducting element (30a) and the second superconducting element (30b) comprising the superconducting joint.

13. A magnetic resonance imaging device (11) comprising a superconducting magnet with a first superconducting element (30a) and a second superconducting element (30b) according to claim 12.

14. A manufacturing device (50) configured for jointing superconducting elements (30) via a method according to one of the claims 1 to 11, comprising a compressing unit (51) configured for mechanically compressing the stack superconducting elements to form a superconducting joint.

15. The manufacturing device (50) according to claim 14, further comprising a press configured for deforming a superconducting element (30) and providing a planar surface (31) on the superconducting element (30) and/or a means for mechanically removing material from a surface of the superconducting element (30).

16. Computer program product that can be loaded into a memory of a programmable processing unit (24) of a manufacturing device (50) according to one of the claims 14 or 15, comprising program code means to perform a method according to any one of claims 1 to 11 when the computer program product is executed in the processing unit (24) of the manufacturing device (50).
